# EUROPEAN PATENT APPLICATION

(11) **EP 1 862 788 A1**
(43) Date of publication of application: **05.12.2007**
(21) Application number: 07004188.4
(22) Date of filing: 28.02.2007
(51) Int. Cl.: G01L 11/02, C23C 16/448, C23C 14/24, C23C 14/26

(54) **Evaporator for organic material, coating installation, and method for use thereof**

(30) Priority: 03.06.2006 EP 06011585
(71) Applicant: Applied Materials GmbH & Co. KG, 63755 Alzenau (DE)
(72) Inventor: Bender, Marcus, 63454 Hanau (DE); Hattendorf, Guido, 63636 Brachttal (DE)
(74) Representative: Zimmermann, Gerd Heinrich

(57) **Abstract**

An evaporator for applying organic vapor to a substrate at a coating rate, the evaporator comprising a distribution pipe with at least one nozzle outlet; and a measurement device for acquiring measurement data about at least one characteristic property of the organic vapor.

## Description

### TECHNICAL FIELD OF THE INVENTION

The present invention relates to an organic evaporator, a coating installation and a method of using thereof. The present invention particularly relates to an organic evaporator with a measurement means for measuring the coating rate of the organic evaporator, a coating installation having such an organic evaporator and a method for use thereof.

### BACKGROUND OF THE INVENTION

Organic evaporators are an essential tool for certain production types of organic light-emitting diodes (OLED). OLEDs are a special type of light-emitting diodes in which the emissive layer comprises a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED display is considerably less than that of traditional LCD displays. Further, the fact that OLEDs can be printed onto flexible substrates opens the door to new applications such as roll-up displays or even displays embedded in clothing.

The functionality of an OLED depends on the coating thickness of the organic material. This thickness has to be within a predetermined range. In the production of OLEDs it is therefore important, that the coating rate at which the coating with organic material is effected lies within a predetermined tolerance range. In other words, the coating rate of an organic evaporator has to be controlled thoroughly in the production process.

In order to do so, it is known in the art to use so called quartz crystal micro balances or quartz resonators for the determination of the coating rate. The measurement of the actual oscillating frequency of these oscillating crystals allows the conclusion on the actual coating rate.

However, these crystals are also coated with organic material in the coating process. Therefore, the crystals have to be replaced periodically because they tolerate only a limited amount of material coating. This reduces their usability particularly in large scale production plants with very long services lives. Furthermore, in order to replace the oscillating crystals, interventions into the vacuum chamber are necessary. Regenerating the vacuum is time-consuming and expensive.

Alternatively, it is known in the art that the deposited layer is analyzed after the deposition is complete in order to determine the coating rate. In this case, the feedback control of the deposition system is only possible with a certain delay. In particular, this procedure can result in one or more substrates being coated with a layer that is out of range before the control can take corrective action. These substrates are rejects.

In view of the above, it is the object of the present invention to provide an organic evaporator, a coating installation, and a method for coating a substrate that overcomes at least some of the problems in the art.

### SUMMARY OF THE INVENTION

The problems in the art are at least partly overcome by the organic evaporator according to claim 1, a coating installation according to claim 16, and a method of coating a substrate according to claim 18. More particularly, an organic evaporator and a coating installation are provided with a long operating time and wherein the rate determination allows an instantaneous control. Further aspects, details, and advantages are evident from the dependent claims, the description, and the accompanying drawings.

In view of the above, the present invention provides an organic evaporator for applying organic vapor to a substrate at a coating rate. The organic evaporator includes a distribution pipe with at least one nozzle outlet and a measurement device for acquiring measurement data about at least one characteristic property of the organic vapor.

According to a further aspect of the present invention, a coating installation for coating substrates is provided. The coating installation includes at least one organic evaporator according to the present invention.

According to another aspect of the present invention a method for applying organic vapor to a substrate is provided with the steps of providing the organic vapor; applying the organic vapor to the substrate; and measuring at least one characteristic property of the organic vapor.

According to yet another aspect of the present invention a method for measuring the coating rate of an organic evaporator is provided with the steps of feeding organic vapor to a hollow body; exhausting the organic vapor from the hollow body via at least one outlet nozzle; and measuring at least one characteristic property of the organic vapor.

### BRIEF DESCRIPTION OF THE DRAWINGS

Embodiments of the present invention are depicted in the drawings and will be described in more detail in the following. Therein:
- Figures 1A, 1B, 2A, and 2B: show various embodiments of the organic evaporator according to the present invention as seen from a substrate to be coated.
- Figures 3A, 3B and 4: show various embodiments of the organic evaporator according to the present invention in a side view perspective.
- Figure 5: shows an embodiment of a coating installation according to the present invention.
- Figures 6A, 6B and 6C: show various embodiments of the organic evaporator according to the present invention in a side view perspective.

### DETAILLED DESCRIPTION OF EMBODIMENTS

Reference will now be made in detail to the various embodiments of the invention, one or more examples of which are illustrated in the figures. Each example is provided by way of explanation of the invention, and is not meant as a limitation of the invention. For example, features illustrated or described as part of one embodiment can be used on or in conjunction with other embodiments to yield yet a further embodiment. It is intended that the present invention includes such modifications and variations.

The present invention provides an evaporator for applying vapor to a substrate at a coating rate. The evaporator has a distribution pipe with at least one nozzle outlet and a measurement device for acquiring measurement data about at least one characteristic property of the vapor.

The rate of the evaporator depends on the pressure of the material which has to be evaporated in the distribution pipe. This pressure corresponds to the vapor pressure of the material. Thus, there is a sufficient high pressure to enable the measurement of a significant signal of a characteristic property of the vapor.

In typical embodiments of the present invention, the absorption rate of the organic vapor is measured as the characteristic property of the organic vapor. Organic materials possess specific absorption bands. According to the Lambert-Beer-law, the absorption depends on the concentration and thus on the pressure of the material to be evaporated within the distribution pipe. Hence, it is possible to deduce the pressure of the material in the distribution pipe from the absorption of certain wavelengths within the distribution pipe. A laser may be used as illumination source for illuminating the vapor. Typically, the intensity of the wavelength distribution of the illumination source used is high at a wavelength at or close to the absorption wavelength of the organic material measured. Typical organic materials are e.g. Alq3, NBP, TNATA and others. Often monomer material is used.

Alternatively, or in addition to the measurement of the absorption as characteristic property of the organic vapor, it is possible to measure the photoluminescence of the organic vapor. The vapor of the organic material is excited by illuminating it with radiation. Typically, the vapor is illuminated with a certain wavelength. The excited molecules fall back to the ground state thereby emitting radiation. The characteristic emission wavelength can be detected using an emission spectrometer as detector. The intensity of the emission depends on the pressure of the material to be evaporated in the distribution pipe. In this way, the emission intensity can be analyzed in order to determine the pressure within the distribution pipe and to conclude on the coating rate.

In typical embodiments, the measurement device comprises one or more, e.g. two detectors and one or more, e.g. two light sources. Generally, the term "light" within the present application refers to all kind of electromagnetic radiation. In typical embodiments, the light emitted has a wavelength of below 1000 nm. In typical embodiments, the light emitted has a wavelength of at least 300 nm. Visible light between 400 nm and 700 nm is often used. The at least one light source may be a laser, a white light lamp, or the like. The at least one detector may be a photodiode, a pin-diode, spectrometer, photo multiplier or the like. The detector may be connected to a multiplier. It is also possible to provide a spectrometer in order to analyze the electromagnetic spectrum.

Depending on the measuring method and/or measured characteristic property and/or organic vapour used, it is within the scope of this invention to apply infra red light or UV light or electromagnetic waves with even higher or lower frequencies.

In typical embodiments, the organic evaporator according to the present invention further comprises an analyzer that is linked to the measurement device, e.g. by a data connection to the detector or its multiplier. It is possible that the analyzer is also linked to the light source in order to compare illumination and absorption and/or photoluminescence emission data. The analyzer typically determines the coating rate based on the information supplied by the measurement device. Further, typically, the analyzer has access to a memory. Data on typical absorption rates and/or photoluminescence activities of the organic vapor may be stored on the memory. For instance, the analyzer can be a personal computer, and the memory can be the hard drive of the personal computer or the like. The analyzer may have an input unit, such as a keyboard or a mouse to allow the operator to have influence on the actions of the analyzer and the units connected to the analyzer such as a controllable seat valve. Further, the analyzer may have an output unit, such as a screen or a plotter, for showing the operator information such as values received from the detector and/or calculation results calculated from these values. The data values measured and the data values stored in the memory may be jointly processed, e.g. compared, in order to determine the actual coating rate.

Typically, the distribution pipe is made of quartz glass or the like. This allows the measurement of the absorption inside the distribution pipe of the OLED-evaporator within a large range of wavelengths and the measurement can be carried out with many different materials. Alternatively, the distribution pipe may be made of stainless steel in which case the pipe needs to be equipped with appropriate windows.

In typical embodiments of the present invention, the measurement is performed in a noncontacting way. The elements of the measurement device, such as a light source and a detector, are typically arranged outside the distribution pipe.

Typically, a gauging step is performed in the method according to the present invention prior to the application of the vapor to the substrate. Generally, the correlation of the deposition rate and the absorption and/or photoluminescence activity is gauged at the beginning of the coating. A gauging step can be repeated during evaporation of substrates e.g. in specific time intervals or constantly. It is also possible that gauging is undertaken during substrate coating. For instance, the coating thickness of the coated substrates can be examined directly after the coating step and be correlated to the characteristic property measured at the time of coating the respective substrate.

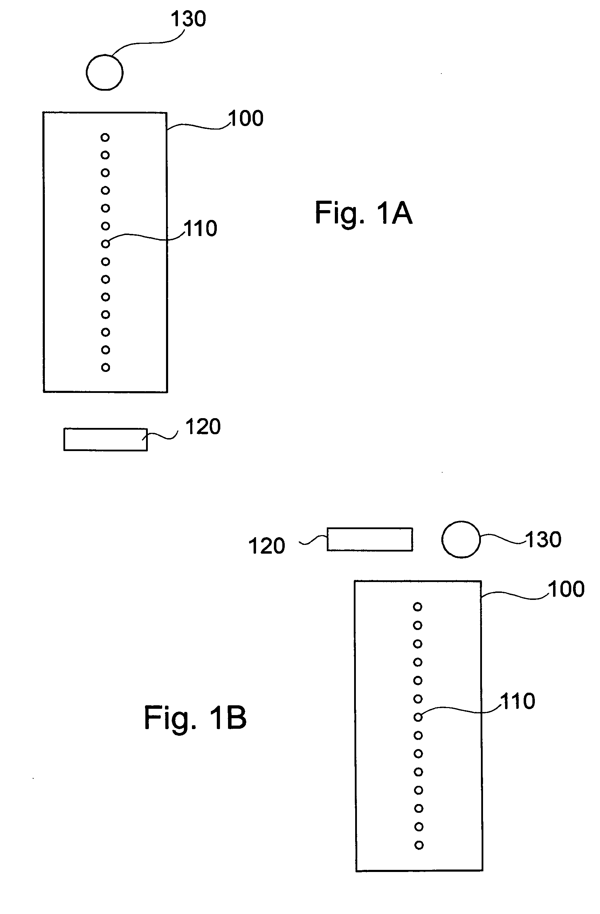

Fig. 1A shows a first embodiment of the evaporator according to the present invention. The distribution pipe 100 of the evaporator comprises a multitude of nozzle outlets 110. The diameter of a typical distribution pipe according to the present invention is between 1 cm and 10 cm, more typically between 4 cm and 6 cm. When evaporating a substrate with organic material, the pressure within the distribution pipe, which is larger than the pressure outside, causes the organic vapour to stream out of the distribution pipe towards a substrate (not shown). In the view shown in Fig. 1A, the substrate would be positioned above the paper plane. In typical methods for coating a substrate, the organic vapor is applied to the substrate in a vacuum atmosphere. The term vacuum shall refer to a pressure of 10⁻² mbar and below. Typically, the nozzle outlets are shaped and arranged such that the flow of vapor of one nozzle outlet overlaps with the flow of vapor of a next neighbour nozzle outlet on the substrate surface.

In order to control the coating rate, the organic evaporator according to the embodiment shown in Fig. 1A comprises a measurement device for acquiring measurement data about a characteristic property of the organic vapour within the distribution pipe 100. The measurement device is typically adapted to acquire measurement data about a characteristic property of the organic vapour within the distribution pipe. The measurement device comprises light source 130 which can be, for instance, a laser or a traditional white or coloured light source having a specific spectral distribution. It is also possible that the light source comprises a light emitting unit having a wide distribution and a filter in front to allow only a specific range of wavelengths to pass. It is also possible that the light source referred to as number 130 represents the end of a fibre optic cable. In other words, in embodiments of the present invention, there may be a fibre optics arranged for transmitting the light to the distribution pipe. The detectors could also be connected via fibre optics. This would enable the use of certain detectors which otherwise would not properly function in particular environments.

The measurement device comprises the detector 120. The detector 120 measures the radiation arriving from the distribution pipe. Typical examples for the detector are pin-diodes, spectrometer, photo diodes, photo multipliers etc. The detectors could also be connected via fibre optics. This would enable the use of certain detectors which otherwise would not properly function in particular environments. Also, it is possible to arrange a filter in front of the detector to let only the photons having a wavelength of interest pass through. This wavelength could be, for instance, the characteristic photoluminescence emission wavelength of the specific organic material in the distribution pipe.

According to one embodiment of the present invention the absorption rate within the distribution pipe is measured as characteristic property of the organic vapour. According to another embodiment of the present invention, the luminescence activity of the organic vapour within the distribution pipe is measured as the characteristic property. The detector 120 in Fig. 1A allows for the measurement of the absorption rate within the distribution pipe and can also be used for the measurement of the photoluminescence. When photoluminescence is measured, it is of advantage, but not necessary, to provide a hole (or numb spot) at the point of direct incidence of the light of the light source on the detector to strengthen the signal quality. It is also possible to arrange the detector in an area outside the direct light passage.

When measuring the absorption rate, it is possible to deduce the pressure of the material in the distribution pipe from the absorption of certain wavelengths within the distribution pipe. As explained before, the coating rate can be deduced from the absorption rate. This information can, in turn, be used for controlling the coating rate.

Generally, the distribution pipe of the present invention can be a hollow body having at least one nozzle outlet. The distribution pipe is typically connected with a feeding unit such as a crucible for feeding the distribution pipe with organic vapor. Typically, the distribution pipe comprises between 15 and 100, typically between 20 and 30 nozzle outlets. The diameter of the nozzle outlets is typically between 0.1 mm and 5 mm, more particular between 1 mm and 2 mm. The distribution pipe can be shaped as tube or the like. In other embodiments, the distribution pipe is a shower head.

If the numbers of nozzles and their respective area of openings are small in comparison to the total size/volume of the distribution tube, then the tube is considered to be closed. The pressure within the tube is more stable and results in better coating processes and pressure measurements.

The embodiment shown in Fig. 1B is similar to the embodiment shown in Fig. 1A with the difference that the detector 120 is positioned at the same side of the organic evaporator as the light source 130. In the embodiment shown, the measurement device 120, 130 is arranged for measuring the photoluminescence of the organic vapour. Alternatively, the detector can also be arranged at the side of the distribution pipe. For this purpose, light is sent into the distribution pipe thereby exciting the organic material. Typically, the light is of a certain wavelength. The excited molecules fall back to the ground state thereby emitting radiation. The characteristic emission wavelength is detected by detector 120 such as an emission spectrometer. As the intensity of the emission depends directly on the pressure of the material to be evaporated, a correlation between pressure and emission intensity can be established an be used to control the rates.

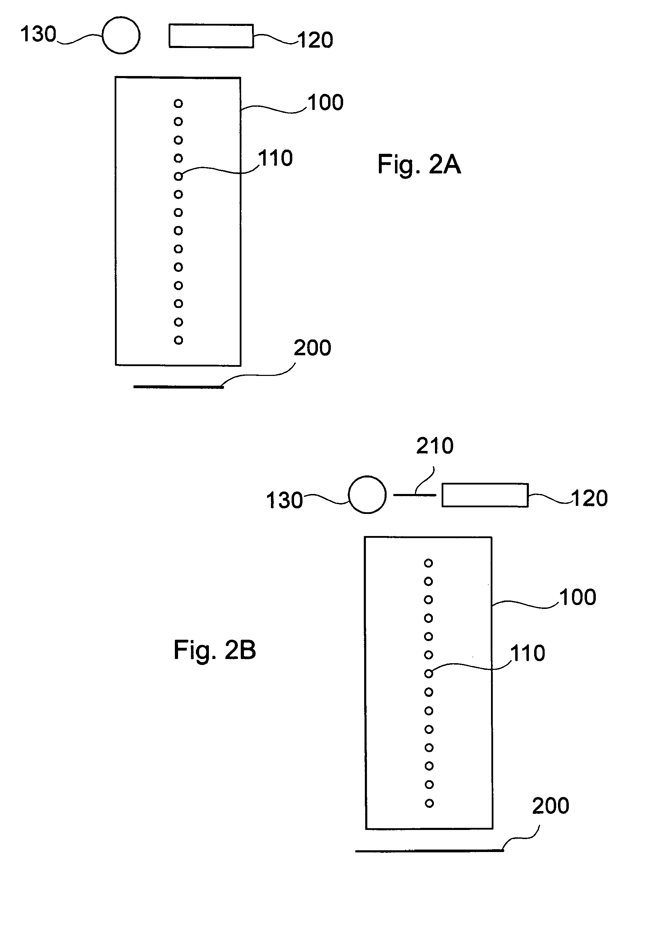

Fig. 2A shows a further embodiment of the organic evaporator according to the present invention. Further to the elements already shown with regard to Fig. 1B, the embodiment of Fig. 2A comprises a mirror 200. The mirror is arranged for reflecting the light emitted by the light source 130 towards the detector 120. Both absorption and photoluminescence can be measured with this embodiment. For instance, if absorption is measured, the distance that the light has to travel through the organic vapour is twice the height of the distribution pipe. Depending on the application and the organic material, the absorption rate within the distribution pipe can be measured more precisely than in an embodiment such as shown in Fig. 1A where the distance that the light has to travel is only one time the height of the distribution pipe.

The travelling distance of the light is further increased according to the embodiment shown in Fig. 2B. Therein, further to the elements already present in Fig. 2A, a further mirror 210 is arranged. The light path of the light emitted by the light source 130 is adjusted such that the travel distance of the light through the distribution pipe is four times the height of the distribution pipe 100.

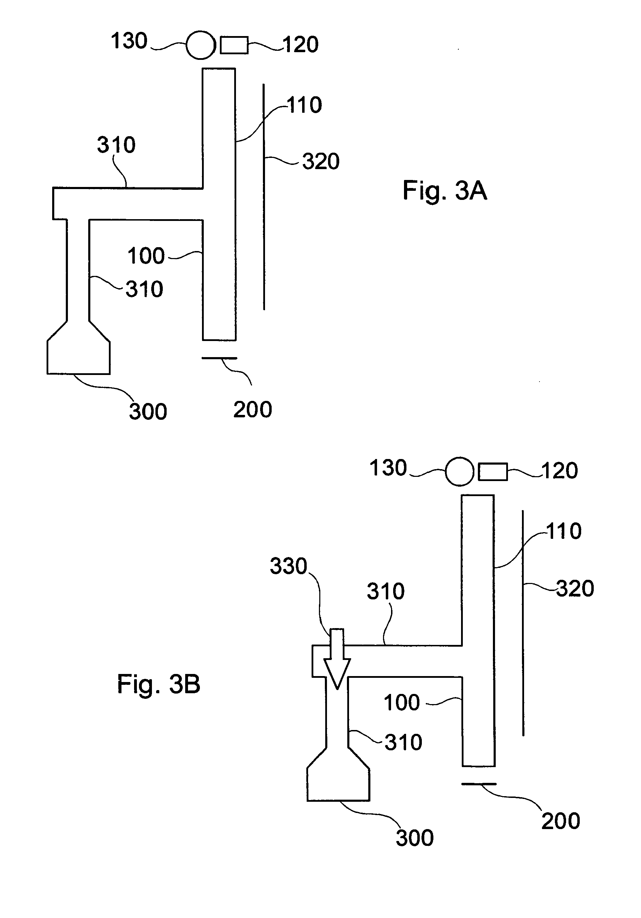

Fig. 3A shows an embodiment of the organic evaporator according to the present invention similar to the embodiment shown in Fig. 2A in a side view perspective. As before, a light source 130 and a detector 120 are positioned above the distribution pipe 100. A mirror 200 is placed below the distribution pipe 100. Depending on the application, it is also possible to arrange the light source, detector and mirror vice versa, that is, the light source could also be positioned below the distribution pipe and the mirror could also be placed above the distribution pipe. The organic evaporator comprises further a crucible 300 and one or more supply tubes 310. The crucible 300 can be filled with the organic material in solid or liquid form. The crucible is then heated to a temperature at which the material partly changes its state of aggregation into vapour.

The various geometrical arrangements of light sources, detectors and/or mirrors can also be made with respect to the supply tube 310. In this case, a characteristic property of the vapour e.g. the pressure, is measured in the supply tube 310 (not shown). In general, the measurement at the distribution pipe is more precise.

Typically, the evaporator has a closed geometry. That is, the holes 110 are the only openings for the vapour to exit the organic evaporator. Due to the higher pressure within the organic evaporator in comparison to the pressure in the surrounding atmosphere, the vapour streams out of the distribution pipe onto the substrate 320. Typically, the pressure within the closed geometry of the organic evaporator corresponds to the vapour pressure of the organic material. This pressure is typically in the 10⁻² mbar range, for instance between 2-4 x 10⁻² mbar. Thereto in contrast, the pressure outside the organic evaporator is typically between 10⁻⁴ mbar and 10⁻⁷ mbar.

It is further possible to arrange a seat valve somewhere between the crucible and the distribution pipe. This is exemplarily shown in the embodiment of Fig. 3B, where the valve 330 is positioned between the vertical part of the supply tube 310 and its horizontal part. In the embodiment shown, the crucible is connected to the distribution pipe via the seat valve. The seat valve 330 is manually or automatically controllable. For instance, the seat valve may be completely closed if the deposition of organic material is to be temporarily stopped. In general, it can be controlled in order to control the organic material density within the organic evaporator. That is, the seat valve can be used for controlling the coating rate of the organic evaporator. Typically, the seat valve can be linked to and be controlled by the analyzer. It is also possible that there are more than one seat valves installed in the organic evaporator according to the present invention. For instance, one seat valve could be controlled manually, and another seat valve could be controlled by the analyzer.

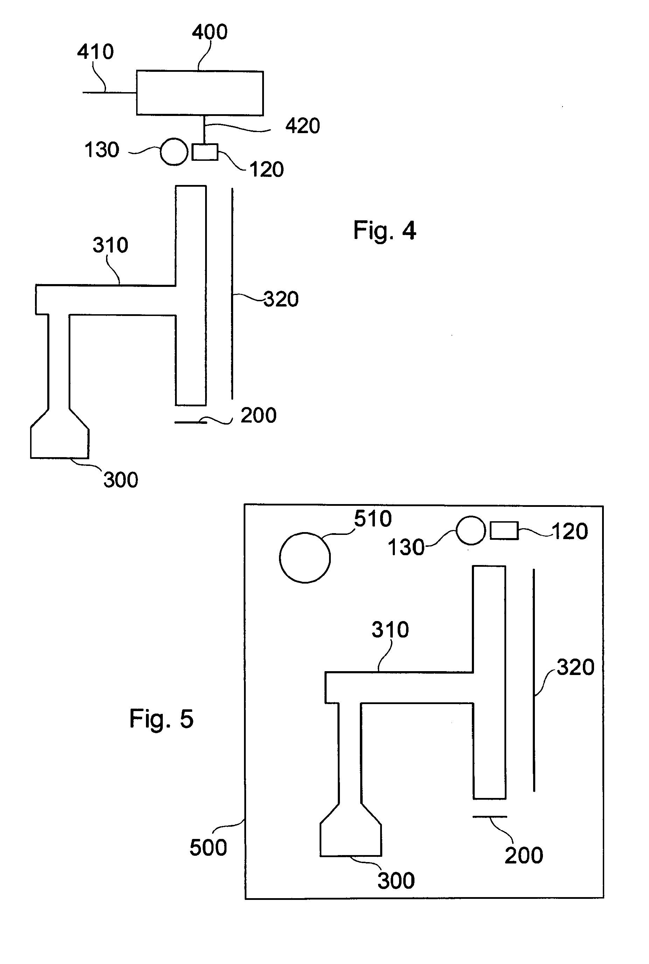

Fig. 4 shows a further embodiment of the present invention. Further to the elements already shown with respect to Fig. 3A, the embodiment of Fig. 4 comprises the analyzer 400. The analyzer is connected to the detector 120 via the connection 420. Further, the analyzer is connected to means for controlling the coating rate of the organic evaporator via the connection 410. For instance, such means can be a seat valve as described with respect to the embodiment of Fig. 3B, or a heat control that controls the temperature of the crucible filled with organic material, or the like. When the organic evaporator is operated, the coating rate is measured by the measurement device comprising the light source 130, the mirror 200, and the detector 120. The information detected by the detector 120 is fed to the analyzer 400 for analyzing the information. The analyzer determines the actual coating rate at which the substrate is coated by evaluating this information. If the coating rate is too high, the means for controlling the coating rate are instructed to reduce the coating rate. As already set forth, this could be done by reducing the seat valve opening (not shown in Fig. 4). Other means for reducing the actual coating rate on the substrate are also within the scope of the present invention. For instance, depending on the process steps before and after the organic coating of the substrate, also the speed of the substrate 320 passing the nozzle outlets 110 could be increased or decreased depending on whether the actual coating rate is too high or too small.

Fig. 5 is a cross sectional side view on an embodiment of a coating installation according to the present invention. Fig. 5 shows the organic evaporator according to the present invention within a coating chamber 500 that is typically evacuated by one or more vacuum pumps 510 during operation.

Typically, the coating installation according to the present invention comprises further process chambers which are positioned before and/or after the organic evaporator. The organic evaporator of the present invention is typically used as a vertical linear organic evaporator. Typically, the substrates are processed in-line. That is, the organic material is horizontally evaporated onto a substrate that is vertically oriented. The substrate is typically continuously transported by an assembly line with different process chambers being positioned in a row. In typical embodiments, the time interval needed for coating is in the range of between 10 seconds and 4 minutes, more typically between 30 sec and 90 sec for one substrate. The coating frequency refers to the number of substrates being coated in the time specified.

The coating installation of the present invention may comprise several organic evaporators according to the present invention. The several process chambers may have different levels of vacuum. Typically, the substrate to be coated undergoes one or more cleaning process steps before entering the chamber for organic evaporating. It is further typical that the substrate is coated with an inorganic layer after the deposition of one or more organic layers. This is due to the fact that organic materials are sensitive to oxygen. Therefore, a cap layer will protect the organic material layer in many embodiments.

Further, as the organic material can hardly be etched in a wet chemical etching process, it is typical that the substrates are structured with the help of shadow masks during the coating. The shadow mask is typically aligned to the substrate. Typically, a metal mask with a high local precision is aligned in relation to the substrate. The substrate is then coated.

In the embodiments shown in Figs. 3A to 5, the measurement device comprises one mirror 200, and both the light source 130 and the detector 120 are positioned above the distribution pipe 100. However, it shall be emphasized that the embodiments shown in Figs. 1A to Fig. 2B are also applicable to the embodiments of Fig. 3A to Fig. 5. In detail, also the embodiments shown in Fig. 3A to Fig. 5 may comprise 0, 1, 2 or more mirrors, and the light source and the detector may be placed at different sides of the distribution pipe. It is also possible according to the present invention that both the detector and the light source are positioned below the distribution pipe.

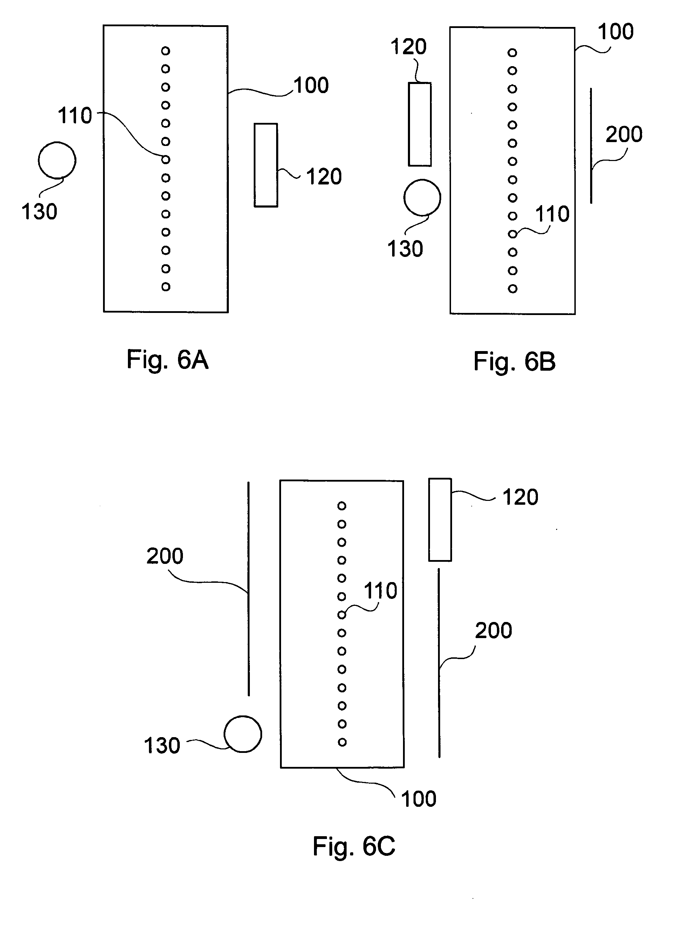

Further, the detector, the light source and possibly a mirror can be positioned beside the distribution pipe. This is shown in the embodiments of Fig. 6A and 6B. It is also possible that there is more than one mirror arranged in embodiments of the present invention. This is exemplarily shown in Fig. 6C.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims of they have structural elements that do not differ from the literal language of the claims, or if they include equivalent structural elements with insubstantial differences from the literal languages of the claims.

## Claims

1. Organic evaporator for applying organic vapor to a substrate at a coating rate, the organic evaporator comprising:
- a distribution pipe (100) with at least one nozzle outlet (110); and
- a measurement device (130; 120, 200) for acquiring measurement data about at least one characteristic property of the organic vapor.

2. The organic evaporator according to claim 1, further comprising
- an analyzer (400) linked to the measurement device for analyzing the measurement data in order to determine the coating rate.

3. The organic evaporator according to any of the preceding claims wherein the at least one characteristic property of the organic vapor comprises the absorption rate of the organic vapor.

4. The organic evaporator according to any of the preceding claims wherein the at least one characteristic property of the organic vapor comprises the photoluminescence activity of the organic vapor.

5. The organic evaporator according to any of the preceding claims wherein the measurement device comprises a light source (130) and/or a detector (120).

6. The organic evaporator according to any of the preceding claims wherein the measurement device comprises a light sensitive detector (120).

7. The organic evaporator according to any of the preceding claims, further comprising a memory for storing data on absorption rate and/or photoluminescence activity of the organic vapor.

8. The organic evaporator according to any of the preceding claims wherein the distribution pipe is arranged in a vertical orientation.

9. The organic evaporator according to any of the preceding claims wherein the measurement device is arranged outside of the distribution pipe (100) for a contact-free measurement of the at least one characteristic property.

10. The organic evaporator according to any of the preceding claims wherein the measurement device comprises at least one mirror unit (200).

11. The organic evaporator according to any of the preceding claims wherein the evaporator is a closed evaporator.

12. The organic evaporator according to any of the preceding claims wherein the diameter of the at least one nozzle outlet is between 0.1 mm and 5 mm.

13. The organic evaporator according to any of the preceding claims further comprising a crucible (300).

14. The organic evaporator according to any of the preceding claims, further comprising a controllable seat valve (330).

15. The organic evaporator according to claim 14 wherein the controllable seat valve (330) is linked to and controlled by the analyzer (400).

16. Coating installation for coating substrates with at least one organic evaporator according to any of the preceding claims.

17. Coating installation according to claim 16 wherein the substrates are processed in-line.

18. Method for applying organic vapor to a substrate with the steps of:
- providing the organic vapor;
- applying the organic vapor to the substrate; and
- measuring at least one characteristic property of the organic vapor.

19. Method for measuring the coating rate of an organic evaporator with the steps of:
- feeding organic vapor to a hollow body;
- exhausting the organic vapor from the hollow body via at least one outlet nozzle; and
- measuring at least one characteristic property of the organic vapor.

20. Method according to claim 18 or 19 wherein the organic vapor is provided within a distribution pipe and the at least one characteristic property of the organic vapor is measured from the organic vapor within the distribution pipe.

21. Method according to any of claims 18 to 20 wherein the providing of the organic vapor comprises the step of producing the organic vapor by heating organic material with the organic material being provided as granulate material or as material wire.

22. Method according to any of claims 18-21 further comprising the step of structuring the substrate with the help of a shadow mask.

23. Method according to any of claims 18-22 wherein the measuring is undertaken contact-free.

24. Method according to any of claims 18-23 wherein the measuring comprises sending electromagnetic radiation into the organic vapor and detecting the absorption rate of the organic vapor.

25. Method according to any of claims 18-24 wherein the measuring comprises sending light into the organic vapor and photoluminescence activity of the organic vapor.

26. Method according to any of claims 24-25 with the further step of reflecting the light.

27. Method according to any of claims 18-26 with the further step of applying a non-organic cover coating to the substrate.

28. Method according to any of claims 18-27 wherein the organic vapor is provided within a distribution pipe and the pressure of the organic vapor within the distribution pipe is adjusted between 2 x 10⁻² mbar and 4 x 10⁻² mbar.
